# EUROPEAN PATENT APPLICATION

(11) **EP 4 810 568 A1**
(43) Date of publication of application: **23.09.2026**
(21) Application number: 24904420.7
(22) Date of filing: 13.12.2024
(51) Int. Cl.: C08L 71/12, C08L 27/12, C08K 7/24, C08K 3/36, C08J 5/24, B32B 15/08, B32B 15/20, H05K 1/03

(54) **RESIN COMPOSITION, PREPREG, METAL FOIL LAMINATE, LAMINATED SHEET, AND PRINTED CIRCUIT BOARD COMPRISING SAME**

(30) Priority: 13.12.2023 KR 20230181231
(71) Applicant: Doosan Corporation, Seoul 04563 (KR)
(72) Inventor: KIM, Yonghyon, Yongin-si, Gyeonggi-do 16858 (KR); KIM, Hyungkyu, Yongin-si, Gyeonggi-do 16858 (KR); SHIN, Jihong, Yongin-si, Gyeonggi-do 16858 (KR)
(74) Representative: Isarpatent
(86) International application number: PCT/KR2024/096900
(87) International publication number: WO 2025/127855

(57) **Abstract**

The present invention relates to a resin composition characterized by a low degree of thermal expansion, a low degree of dielectricity, and a high degree of thermal resistance, and a prepreg, a metal foil laminate, a laminated sheet, and a printed circuit board comprising same. The resin composition comprises a polyphenylene oxide-based resin, a hollow inorganic filler having a porosity of 60-90%, a fluorine resin filler, and a dispersant.

## Description

### [TECHNICAL FIELD]

The present disclosure relates to a resin composition having low thermal expansion, low dielectric properties, and high heat resistance, as well as to prepregs, metal foil laminates, laminate sheets, and printed circuit boards including the same.

### [BACKGROUND ART]

Recently, with the emergence of a hyper-connected intelligent era driven by artificial intelligence, big data, and autonomous vehicles, the development and distribution of various electronic devices such as smartphones have accelerated, and thus next-generation 5G or 6G communication, capable of wirelessly transmitting high-speed and large-capacity data, is being actively pursued in place of existing 4G LTE communication. In particular, with the spread of autonomous vehicles, smart cities, and smart factories, high-frequency or ultra-high-frequency bands are being used to transmit and receive large volumes of data without delay. The frequencies currently in use are gradually shifting from sub-6 (4.5 GHz) to 28 and 40 GHz, and it is expected that ultra-high frequencies of 100 GHz or higher will be used in the future. However, as the operating frequency band of communication and electronic devices increases, transmission loss of electrical signals increases, which may cause problems such as heat generation, signal attenuation, and signal delay.

Accordingly, in order to reduce transmission loss, materials having low permittivity and a low dielectric loss tangent have been developed. For example, fluoropolymer resins, liquid crystal polymers (LCP), and modified polyimides (modified PI or MPI) that are applicable to high-frequency applications have been used in printed circuit boards; however, improving processability, such as heat resistance and adhesion to copper foil, as well as dielectric properties has remained challenging.

### [SUMMARY OF THE INVENTION]

### [TECHNICAL PROBLEM]

The present disclosure aims to provide a resin composition capable of manufacturing a prepreg that has a low coefficient of thermal expansion (CTE), excellent low dielectric properties, heat resistance, and resin flowability, and allows for a lamination process without a high-temperature molding process.

In addition, the present disclosure aims to provide a prepreg, a metal foil laminate, a laminated sheet, and a printed circuit board usable in high frequency to ultra-high frequency bands using the aforementioned resin composition.

### [TECHNICAL SOLUTION]

To achieve the above objective, the present disclosure provides a resin composition comprising a polyphenylene oxide-based resin; a hollow inorganic filler having a porosity of 60% to 90%; and a dispersant.

According to one example, the hollow inorganic filler may have a dielectric constant (Dₖ) in the range of 1 to 3 at 25°C and 10 GHz.

According to another example, the hollow inorganic filler may have an average particle size (D50) in the range of 0.5 to 50 µm.

According to another example, the hollow inorganic filler may contain hollow silica.

According to another example, the resin composition may additionally include a fluoropolymer filler.

According to another example, the fluoropolymer filler may have a dielectric constant (Dk) in the range of 2 to 3 at 25°C and 10 GHz.

According to another example, the fluoropolymer filler may contain one or more selected from the group consisting of polytetrafluoroethylene (PTFE), perfluoroalkoxyalkane (PFA), tetrafluoroethylene-hexafluoropropylene copolymer (FEP), polychlorotrifluoroethylene (PCTFE), ethylene-tetrafluoroethylene copolymer (ETFE), tetrafluoroethylene-chlorotrifluoroethylene copolymer (TFE/CTFE), ethylene-chlorotrifluoroethylene copolymer (ECTFE), and polychlorotrifluoroethylene (PCTFE).

According to another example, the dispersant may contain a non-ionic dispersant.

According to another example, the dispersant may contain one or more selected from the group consisting of polyoxyethylene glycol alkylphenol ether-based dispersants, polysorbate-based dispersants, and poly(oxyethylene)alkyl ether-based dispersants.

According to another example, the resin composition may further include at least one selected from the group consisting of a curing agent, a reaction initiator, a curing accelerator, an additive, and a solvent.

According to another example, the resin composition may comprise, based on the total amount of the resin composition, 10 to 70 wt% of a polyphenylene oxide-based resin; 5 to 40 wt% of a hollow inorganic filler; and 0.0001 to 5 wt% of a dispersant.

According to another example, the cured product of the resin composition may have a dielectric constant (Dₖ) in the range of 1.5 to 2.2 at 25°C and 10 GHz.

In addition, the present disclosure provides a prepreg comprising the aforementioned resin composition.

According to one example, the prepreg may have a dielectric constant (Dₖ) of 2.5 or less at 25°C and 10 GHz.

Furthermore, the present disclosure provides a metal foil laminate comprising the aforementioned resin composition.

Meanwhile, the present disclosure provides a printed circuit board comprising the aforementioned resin composition.

### [ADVANTAGEOUS EFFECTS OF THE INVENTION]

The resin composition according to the present disclosure exhibits a low coefficient of thermal expansion (CTE), a high glass transition temperature (Tg), a low dielectric constant, and excellent resin flowability. Accordingly, it provides excellent processability when applied to a printed circuit board and can further improve the low dielectric loss, heat resistance, and low thermal expansion properties of the printed circuit board.

In addition, the resin composition according to the present disclosure enables the manufacture of prepregs that can undergo a lamination process without requiring a high-temperature molding process.

Therefore, the resin composition of the present disclosure can be usefully used for parts of printed circuit boards used in various electrical and electronic devices such as mobile communication devices handling ultra-high-frequency signals of 100 GHz or higher, network-related electronic devices such as base station devices, servers, and routers thereof, and large computers.

### [MODES FOR CARRYING OUT THE INVENTION]

Hereinafter, the present disclosure will be described.

Unless otherwise defined, all terms (including technical and scientific terms) used herein have the same meaning as commonly understood by one of ordinary skill in the art to which the present disclosure belongs. Also, terms such as those defined in commonly used dictionaries are not to be interpreted in an idealized or overly formal sense unless expressly so defined herein.

Throughout this specification, when a part is referred to as "including" a component, it should be understood as an openended term implying the possibility of further including other components, rather than excluding other components, unless otherwise stated.

Furthermore, throughout the specification, the terms "on" or "above" mean not only being located directly above or directly below a target part, but also including cases where another part is present therebetween, and do not necessarily mean being located at an upper side with respect to the direction of gravity.

In addition, terms such as "first", "second", and the like in the present specification do not indicate any order or importance, but are used to distinguish components from each other.

### <Resin composition>

Conventionally, fluoropolymer resins have been used as matrix resins for prepregs in order to minimize radio wave loss in the frequency bands used for 5G to 6G communication. In this case, since fluoropolymers exhibit low dielectric constant (Dₖ) and dielectric loss (D_{f}), it was possible to realize prepregs with low dielectric properties and low dielectric loss. However, fluoropolymer resin is a thermoplastic resin with a high melting point of about 300°C or higher. For this reason, when manufacturing prepregs containing fluoropolymer resin, a high-temperature molding process had to be carried out for an extended period at temperatures of about 300°C or higher, resulting in low productivity and increased manufacturing costs. Furthermore, the coefficient of thermal expansion of fluoropolymer resin is high. For this reason, when a prepreg containing fluoropolymer is applied to a metal foil laminate (e.g., a copper foil laminate), partial separation may occur between the prepreg and the metal foil laminate due to the difference in the coefficient of thermal expansion between the prepreg and the metal foil.

To solve the aforementioned problems, the present disclosure intends to use a resin composition comprising a polyphenylene oxide-based resin, a hollow inorganic filler, and a dispersant. In general, since transmission loss is proportional to the dielectric constant (Dk) and dielectric loss (Df) of an insulator, the present disclosure employs a hollow inorganic filler containing air therein in order to achieve a dielectric constant lower than the intrinsic dielectric constant of the polyphenylene oxide-based resin. However, if the porosity of the hollow inorganic filler is too small, the effect of reducing the dielectric constant may be small, whereas if the porosity of the hollow inorganic filler is too large, the hollow inorganic filler may break during the lamination process, which could lead to an increase in the dielectric constant.

Accordingly, the present disclosure comprises a polyphenylene oxide-based resin, a hollow inorganic filler, and a dispersant, wherein the hollow inorganic filler has a porosity controlled to a range of 60% to 90%. Accordingly, the resin composition according to the present disclosure exhibits a low coefficient of thermal expansion (CTE), a high glass transition temperature (Tg), a low dielectric constant, and excellent resin flowability. As a result, it provides excellent processability when applied to a printed circuit board and can further enhance the low dielectric loss, heat resistance, and low thermal expansion characteristics of the printed circuit board. In addition, the resin composition according to the present disclosure enables the manufacture of prepregs that can undergo a lamination process without requiring a high-temperature molding process. Therefore, the resin composition of the present disclosure can be usefully used for parts of printed circuit boards used in various electrical and electronic devices such as mobile communication devices handling ultra-high-frequency signals of 100 GHz or higher, network-related electronic devices such as base station devices, servers, and routers thereof, and large computers.

According to one example, the resin composition according to the present disclosure comprises (a) a polyphenylene oxide-based resin; (b) a hollow inorganic filler having a porosity of 60% to 90%; and (c) a dispersant.

According to another example, the resin composition according to the present disclosure may additionally include a fluoropolymer filler in addition to the aforementioned components.

According to another example, the resin composition according to the present disclosure may additionally include one or more selected from the group consisting of a curing agent, an initiator, an additive, and a solvent, in addition to the aforementioned components.

Hereinafter, each component of the resin composition according to the present disclosure will be described.

### (a) Polyphenylene oxide-based resin

In the resin composition according to the present disclosure, the poly(phenylene oxide) resin (PPO) is used as the base resin and has excellent electrical insulation, heat resistance, water resistance, dimensional stability, and low dielectric properties, does not contain environmentally harmful components such as halogens, and has self-extinguishing properties, thereby facilitating the assurance of flame retardancy.

Non-limiting examples of such polyphenylene oxide-based resins include poly(2,3-dimethyl-6-ethyl-1,4-phenylene ether), poly (2-methyl-6-chloromethyl-1, 4-phenylene ether), poly(2-methyl-6-hydroxyethyl-1,4-phenylene ether), poly(2-methyl-6-n-butyl-1,4-phenylene ether), poly(2-ethyl-6-isopropyl-1,4-phenylene ether), poly(2-ethyl-n-propyl-1,4-phenylene ether), poly(2,3,6-trimethyl-1,4-phenylene ether), poly(2-ethyl(4'-methylphenyl)-1,4-phenylene ether), poly(2-bromo-6-phenyl-1,4-phenylene ether), poly(2-methyl-6-phenyl-1,4-phenylene ether), and poly(2-phenyl-1,4-phenylene ether), poly(2-chloro-1,4-phenylene ether), poly(2-methyl-1,4-phenylene ether), poly(2-chloro-6-ethyl-1,4-phenylene ether), poly(2-chloro-6-bromo-1,4-phenylene ether), poly(2,6-di-n-propyl-1,4-phenylene ether), poly(2-methyl-6-isopropyl-1,4-phenylene ether), poly(2-chloro-6-methyl-1,4-phenylene ether), poly(2-methyl-6-ethyl-1,4-phenylene ether), poly(2,6-dichloro-1,4-phenylene ether), poly(2,6-diethyl-1,4-phenylene ether), poly(2,6-dimethyl-1,4-phenylene ether), and poly(2,6-dibromo-1,4-phenylene ether); other examples include poly(2,6-dichloro-1,4-phenylene ether), and copolymers such as copolymers of 2,6-dimethylphenol and other phenols (e.g., 2,3,6-trimethylphenol). In addition, it may also be modified with maleic anhydride, fumaric acid, or the like.

In the resin composition of the present disclosure, the polyphenylene oxide-based resin may be included in an amount of about 10 to 70 wt% based on the total amount (100 wt%) of the resin composition, specifically about 30 to 70 wt%, and more specifically about 40 to 70 wt%. If the content of the polyphenylene oxide-based resin is less than 10 wt%, the dielectric constant or rigidity of the overall resin composition may decrease, whereas if the content exceeds 70 wt%, heat resistance may be reduced.

### (b) Hollow Inorganic filler

In the resin composition according to the present disclosure, the hollow inorganic filler is a filler having an internal void (empty space) within the particle. These hollow inorganic fillers, like conventional inorganic fillers, can reduce the difference in the coefficient of thermal expansion (CTE) between the resin layer and other layers, thereby improving the bending properties, low thermal expansion, and mechanical strength (toughness) of the final product.

However, because hollow inorganic fillers contain air within their internal voids, the size of the enclosed air layer can influence the dielectric constant of the resin layer. Accordingly, the present disclosure includes a hollow inorganic filler having a porosity in the range of about 60% to 90%, as described above. Here, the porosity can be calculated as (d/D)³ * 100 (%) (where D is the total diameter (outer diameter) of the particle, measured with a particle size analyzer, and d is the diameter (inner diameter) of the internal air layer, calculated by observing the cross-section of the hollow inorganic filler with an electron microscope and measuring the thickness of the shell). If the porosity of the hollow inorganic filler is less than 60%, the proportion of air within the filler is relatively reduced, and thus the effect of lowering the dielectric constant may be insufficient. On the other hand, if the porosity exceeds 90%, the hollow inorganic filler may be crushed during the lamination process, which may result in an increase in the dielectric constant.

The hollow inorganic filler may have an average particle size (D50) in the range of about 0.5 to 50 µm, specifically in the range of about 1 to 25 µm. Here, the average particle size (D50) of the hollow inorganic filler can be measured according to ASTM D4464.

In addition, the hollow inorganic filler can have a dielectric constant (Dₖ) in the range of about 1 to 3 at 25°C and 10 GHz. Here, the dielectric constant (Dₖ) of the hollow inorganic filler was measured at 25°C and 10 GHz using the SPDR method (IEC 61189-2-721).

The components of the above hollow inorganic filler may include, but are not limited to, silica, alumina, calcium carbonate, magnesium carbonate, magnesia, calcium silicate, titanium oxide, antimony oxide, aluminum borate, barium titanate, strontium titanate, calcium titanate, magnesium titanate, bismuth titanate, titanium oxide, barium zirconate, calcium zirconate, boron nitride, silicon nitride, borosilicate, etc. These may be used individually or in a mixture of two or more types. Among these, silica is preferred due to its high mechanical strength and low coefficient of thermal expansion.

According to one example, the hollow inorganic filler may be hollow silica. These hollow silica may further include other metal elements (e.g., boron, sodium, calcium, aluminum, etc.) in addition to the silica (SiO₂) component, and specifically may be composed of a borosilicate component, and more specifically may include about 75 to 85 wt% silica, about 10 to 15 wt% boron oxide, about 1 to 6 wt% sodium oxide, and 1 to 3 wt% aluminum oxide.

The shape of the hollow inorganic filler may be spherical particles, but may also be irregular particles.

The hollow inorganic filler may be surface-treated with a surface treatment agent. The surface treatment agent is not particularly limited, provided that it is commonly known in the art, and may include, for example, a silane coupling agent and the like. In this case, the silane coupling agent may be used in an amount of about 0.01 to 20 parts by weight, specifically about 0.1 to 10 parts by weight, and more specifically about 0.1 to 5 parts by weight based on 100 parts by weight of the hollow inorganic filler.

The silane coupling agent usable in the present disclosure is not particularly limited, provided that it is commonly known in the art, and may include vinyl-based, epoxy-based, methacryloxy-based, amino-based, mercapto-sulfide-based, or ureide-based silane coupling agents, which may be used individually or in combination of two or more types. Such a silane coupling agent may improve adhesion between the hollow inorganic filler and other components during curing of the resin composition.

According to an example, the silane coupling agent may be a vinyl-based silane coupling agent such as vinyltriethoxysilane, vinyltripropoxysilane, vinyltriisopropoxysilane, and vinyltributoxysilane. In this case, due to excellent compatibility with a modified polyphenylene ether having unsaturated functional groups such as vinyl and/or allyl groups at both ends, the permittivity and dielectric loss tangent can be reduced, while moisture resistance, heat resistance, and processability can be further improved.

The aforementioned silane coupling agent may not only be used to surface-treat the hollow inorganic filler, but may also be further incorporated as a component of the resin composition. The content of such a silane coupling agent may be about 0.0001 wt% to 10 wt%, specifically about 0.01 wt% to 5 wt%, and more specifically about 0.1 wt% to 3 wt%, based on the total amount of the resin composition. In this case, the silane coupling agent improves the dispersibility of the inorganic filler, thereby enhancing the dielectric properties of a cured product of the resin composition, such as a resin layer or a prepreg to which the resin composition is applied.

In the resin composition of the present disclosure, the content of the hollow inorganic filler may be in the range of about 5 to 40 wt%, specifically about 15 to 40 wt%, and more specifically about 25 to 35 wt%, based on the total amount of the resin composition. If the content of the hollow inorganic filler is less than about 5 wt%, the effect of reducing the dielectric constant may be insufficient. Meanwhile, if the content of the hollow inorganic filler exceeds about 40 wt%, the moldability of the resin composition may be reduced.

### (c) Dispersant

In the resin composition according to the present disclosure, the dispersant prevents hollow inorganic fillers or fluoropolymer fillers from aggregating, thereby improving the resin flowability of the resin composition.

According to one example, the dispersant may include a non-ionic dispersant (non-ionic surfactant).

Examples of the dispersant include polyoxyethylene glycol alkylphenol ether-based dispersants such as Triton X-100 (Poly oxyethylene glycol octyl phenol ether); polysorbate-based dispersants such as Tween 20 (Polysorbate 20) and Tween 80 (Polysorbate 80); and poly(oxyethylene)alkyl ether-based dispersants such as Brij L23, but are not limited thereto. These may be used individually or in a mixture of two or more types.

In the resin composition of the present disclosure, if the content of the dispersant is excessively high, the dielectric constant and heat resistance may deteriorate, whereas if it is too low, the dispersing effect may be insufficient. Accordingly, the content of the dispersant can be adjusted to a range of about 0.0001 to 5 wt% based on the total weight of the resin composition. However, if the resin composition of the present disclosure includes a fluoropolymer filler, the content of the dispersant may be about 0.0001 to 10 parts by weight, specifically about 0.01 to 5 parts by weight, more specifically about 0.1 to 3 parts by weight, based on 100 parts by weight of the fluoropolymer filler.

### (d) Fluoropolymer filler

The resin composition according to the present disclosure may additionally include a fluoropolymer filler. The fluoropolymer filler is a fluorine-containing resin particle containing fluorine (F), and is a particulate organic filler, such as a powder or fiber, that is solid at room temperature (about 20±5°C). The fluoropolymer filler is dispersed in a polyphenylene oxide-based resin by a dispersant along with hollow inorganic fillers while maintaining their particle shape during the drying or semi-curing of the resin composition, and are subsequently melted by a high-temperature press and incorporated into the cured resin as a polymer matrix component. Therefore, fluoropolymer fillers can not only impart low dielectric constant and low dielectric loss characteristics to the cured resin product, but can also improve heat resistance and enhance adhesion to a fiber-containing substrate or metal foil of the prepreg.

In addition, the fluoropolymer filler can have a dielectric constant (Dk) of about 2 to 3 at 25°C and 10 GHz. In this manner, because the fluoropolymer filler exhibits a low dielectric loss tangent and a low permittivity, the cured product of the resin composition can exhibit low dielectric constant and low dielectric loss characteristics. Here, the dielectric constant (Dk) of the fluoropolymer filler was measured at 25°C and 10 GHz using the SPDR method (IEC 61189-2-721).

The fluoropolymer filler may have a melting point (Tm) in the range of approximately 280 to 340°C. In this case, the fluoropolymer filler exists as a solid phase within the resin composition, similar to the hollow inorganic filler, and functions to reduce the dielectric constant.

The fluoropolymer filler may have a melt flow rate (MFR) of about 0.0001 to 50 g/10min at about 372°C and about 5 kg according to the ISO 1133-1 test method.

The fluoropolymer filler usable in the present disclosure is not particularly limited, provided that it is a particle formed from a fluorine-containing resin commonly used in the art. the fluoropolymer filler may contain one or more selected from the group consisting of polytetrafluoroethylene (PTFE), perfluoroalkoxyalkane (PFA), tetrafluoroethylene-hexafluoropropylene copolymer (FEP), polychlorotrifluoroethylene (PCTFE), ethylene-tetrafluoroethylene copolymer (ETFE), tetrafluoroethylene-chlorotrifluoroethylene copolymer (TFE/CTFE), ethylene-chlorotrifluoroethylene copolymer (ECTFE), and polychlorotrifluoroethylene (PCTFE), but are not limited thereto. Among these, PFA and PTFE are preferred because they exhibit a low dielectric loss tangent (Df) of 0.0002 or less.

These fluoropolymer fillers may have an average particle size (D50₎in the range of about 1 to 50 µm. In this case, the fluoropolymer filler is not only uniformly dispersed within the resin composition without aggregation, but the handling properties of the resin composition after coating can also be improved. However, in the present disclosure, one type of fluoropolymer filler with the same average particle size may be used individually, or two or more types of fluoropolymer fillers with different average particle sizes may be used in combination. Here, the average particle size (D50) of the fluoropolymer filler can be measured according to ASTM D4464.

In addition, the shape of the fluoropolymer filler is not particularly limited and may include, for example, spherical, flake, dendritic, conical, pyramidal, or amorphous shapes. These may be used individually or in combination of two or more types. According to one example, the shape of the fluoropolymer filler can be spherical. In this case, the surface area of the fluoropolymer filler is minimized, thereby improving the processability of the resin composition and imparting isotropic properties to the resin layer.

In the resin composition of the present disclosure, the content of the fluoropolymer filler may be in the range of more than 0 wt% to 50 wt% based on the total amount of the resin composition, specifically in the range of about 10 to 50 wt%, and more specifically in the range of about 10 to 30 wt%. By controlling the content of the fluoropolymer filler to the aforementioned range, the resin composition can form a resin layer or prepreg with a low dielectric constant.

### (e) Curing agent

The resin composition according to the present disclosure may further include a curing agent, if necessary.

The curing agent is a cross-linking curing agent that cross-links the polyphenylene oxide-based resin three-dimensionally to form a network structure, thereby improving the heat resistance and fluidity of the resin composition, and further enhancing the peel strength between the resin layer and other substrates.

Examples of curing agents usable in the present disclosure include divinylbenzene of the vinylbenzyl oxide compound series; allyl oxide compounds prepared by the reaction of divinylnaphthalene, divinyldiphenyl, styrene monomer, phenol, and allyl chloride; diene series such as triallyl isocyanurate (TAIC), triallycyanurate (TAC), 1,2,4-trivinylcyclohexane, 1,7-octadiene, 1,9-decadien; and di-4-vinylbenzyl oxide. The aforementioned curing agents may be used individually or in combination of two or more types. These are desirable because they not only have excellent compatibility but also superior moldability, low dielectric constant values, and excellent heat resistance and reliability.

In the resin composition of the present disclosure, the content of the curing agent may be in the range of about 5 to 50 parts by weight, specifically about 10 to 40 parts by weight, based on 100 parts by weight of the polyphenylene oxide-based resin. If the content of the curing agent is within the aforementioned range, the resin composition exhibits adequate curability, moldability, and adhesion.

### (f) Reaction initiator

The resin composition according to the present disclosure may further include a reaction initiator, if necessary. The reaction initiator generates radicals upon heating or the like, and can further promote curing of the polyphenylene oxide-based resin and/or the curing agent, thereby improving properties such as heat resistance of the resin.

Non-limiting examples of the reaction initiator usable in the present disclosure include α,α'-bis(t-butylperoxy-m-isopropyl)benzene, 2,5-dimethyl-2,5-di(t-butyl peroxy)-3-hexyne, benzoyl peroxide, 3,3',5,5'-tetramethyl-1,4-diphenoxyquinone, chloranil, 2,4,6-tri-t-butylphenoxyl, t-butylperoxyisopropyl monocarbonate, and azobisisobutyronitrile. Additionally, metal carboxylate salts may also be used.

The content of the reaction initiator may be about 1 wt% to 5 wt%, and specifically about 0.1 wt% to 2 wt%, based on the total weight of the resin composition.

### (g) Additives

In addition to the aforementioned components, the resin composition of the present disclosure may further comprise, as needed, various polymers such as a thermosetting resin or a thermoplastic resin generally known in the art and an oligomer thereof (e.g., phenoxy resin, polyvinyl acetal resin, polyimide, polyamideimide, polyethersulfone, and polysulfone), solid-phase rubber particles, or additives such as ultraviolet absorbers, antistatic agents, flame retardants, antioxidants, polymerization initiators, dyes, pigments, thickeners, leveling agents, and stress-relieving agents, which are generally known in the art, provided that they do not impair the intrinsic properties of the resin composition.

For example, the additives may include organic fillers such as silicone-based powder, nylon powder, and fluoropolymer powder; thickeners such as orben and benton; polymeric defoaming agents or leveling agents such as silicone-based or fluoropolymer-based agents; adhesion-imparting agents such as imidazole-based, thiazole-based, triazole-based, or silane-based coupling agents (e.g., epoxysilane, aminosilane, and vinylsilane); coloring agents such as phthalocyanine and carbon black; release agents such as higher fatty acids, higher fatty acid metal salts, and ester-based waxes; stress-relieving agents such as modified silicone oil, silicone powder, and silicone resin; and flame retardants such as A, B, and C. In addition, additives commonly used in a resin composition used for manufacturing an electronic device, particularly a printed wiring board, may be included.

The content of the additive may be about 0.001 wt% to 20 wt%, specifically about 0.01 wt% to 5 wt%, and more specifically about 0.01 wt% to 1 wt%, based on the total amount of the resin composition.

### (h) Organic solvent

The aforementioned resin composition of the present disclosure may be in the form of a resin varnish containing an organic solvent. In this case, the resin composition may be dissolved or dispersed in the organic solvent.

The organic solvent usable in the present disclosure may be a conventional organic solvent known in the art without limitation, and examples thereof include acetone, cyclohexanone, methyl ethyl ketone, toluene, xylene, and tetrahydrofuran, which may be used alone or in a mixture of two or more types thereof.

The content of the organic solvent may be a balance satisfying 100 parts by weight of the entire varnish using the composition ratio of the aforementioned composition, and is not particularly limited.

As described above, the resin composition of the present disclosure is characterized by comprising a polyphenylene oxide-based resin having excellent electrical properties in the high frequency to ultra-high frequency band, a hollow inorganic filler having a specific porosity, a fluoropolymer filler, and a dispersant, and is a high-frequency, low-dielectric-constant, low-loss resin composition that can be used to manufacture prepregs, sheets, films, tapes, laminates, or printed circuit boards. In addition, the resin composition of the present disclosure has a low coefficient of thermal expansion (CTE) and excellent heat resistance and resin flowability.

According to one example, the cured product (resin layer) of the resin composition according to the present disclosure may have a dielectric constant (Dₖ) in the range of about 1.5 to 2.2 at 25°C and 10 GHz. Here, the dielectric constant (Dₖ) of the cured product was measured at 25°C and 10 GHz using the SPDR method (IEC 61189-2-721).

The resin composition of the present disclosure can be dissolved in a suitable organic solvent or molded into a film to form a core layer or build-up layer of a multilayer substrate, and can be used as a substrate material, sheet, laminate, resin-coated copper foil, copper-clad laminate, TAB tape, printed circuit board, prepreg, adhesive sheet, etc.

### <Prepreg>

Meanwhile, the present disclosure provides a prepreg comprising the aforementioned resin composition.

The prepreg according to the present disclosure is a fiber-reinforced composite material, and comprises a fiber-containing substrate; and the aforementioned resin composition impregnated in the fiber-containing substrate.

The resin composition may be a resin varnish in a form dissolved or dispersed in an organic solvent. In addition, the resin composition may be coated or impregnated onto a fiber-containing substrate and then heat-cured to a B-stage (semi-cured state) to form a sheet-shaped insulating substrate.

The fiber-containing substrate is a flexible fiber assembly that can be arbitrarily bent, and is a portion supporting a metal foil laminate or a printed circuit board. Since the fiber-containing substrate contains a fiber, the permittivity and dielectric loss tangent of the metal foil laminate or the printed circuit board can be lowered, thereby improving low dielectric loss properties. In addition, the fiber-containing substrate can adhere closely to the resin composition during manufacturing to exhibit excellent flexibility, heat resistance, and adhesion.

The fiber-containing substrate may be a plurality of fibers, or a substrate or a member formed of a fiber such as a yarn, a woven fabric, a non-woven fabric, a knitting, and a braid.

Non-limiting examples of the fiber include a vegetable fiber such as cotton and hemp, an animal fiber such as wool and silk, a regenerated fiber such as rayon, a synthetic fiber such as polyester, acrylic, nylon, and polyurethane, an inorganic fiber such as a glass fiber and a carbon fiber, and a metal fiber, which may be used individually or in a mixture of two or more types thereof. Among them, the inorganic fiber such as a glass fiber and a carbon fiber has a low moisture content, so that a pore is not formed in the fiber-containing substrate during subsequent curing, and also has excellent thermal stability.

According to an example, the fiber-containing substrate may be a plurality of glass fibers such as E-glass, D-glass, S-glass, NE-glass, T-glass, and Q-glass, a glass paper, a glass roving, a glass yarn, a woven fabric, glass chopped strands, a glass chopped strands mat, a glass roving cloth, and a glass surfacing mat. However, the present disclosure is not limited thereto.

A thickness of the fiber-containing substrate is not particularly limited, and may be, for example, in a range of about 0.01 mm to 0.3 mm.

Meanwhile, the surface of the fiber-containing substrate may be treated with a silane coupling agent. In this case, a method of treating with the silane coupling agent may be a conventional method known in the art. A description of the silane coupling agent is identical to that described for the aforementioned resin composition, and thus will be omitted.

According to an example, the surface of the fiber-containing substrate may be treated with the same silane coupling agent as the silane coupling agent used for the hollow inorganic filler, and specifically, may be treated with a vinyl group-containing silane coupling agent. In this case, adhesion between the fiber-containing substrate and a (semi-)cured product of the resin composition is further improved, and the metal foil of the metal foil laminate and the prepreg are more firmly adhered to each other, thereby suppressing the peeling of the metal foil.

The prepreg of the present disclosure may be manufactured by known methods in the art, such as a hot-melt method or a solvent method. For example, the prepreg may be manufactured by coating or impregnating the resin composition on a glass fabric and then curing the same to a semi-cured state or a B-stage by heating. In this case, the curing temperature may be in a range of about 110°C to 180°C, and a curing time may be about 1 minute to 10 minutes. However, it is appropriate to adjust the curing temperature and the curing time according to a curing condition of the resin composition.

The prepreg 110 of the present disclosure described above may have a dielectric constant (Dₖ) of about 2.5 or less, specifically 1.5 to 2.2, at 25°C and 10 GHz. Here, the dielectric constant (Dₖ) of the prepreg was measured at 25°C and 10 GHz using the SPDR method (IEC 61189-2-721).

### <Metal Foil Laminate>

Provided is a metal foil laminate comprising the aforementioned resin composition according to the present disclosure.

According to an example, the metal foil laminate according to the present disclosure comprises a metal foil; and a resin layer disposed on one surface or both surfaces of the metal foil and formed of the resin composition.

According to another example, the metal foil laminate according to the present disclosure comprises a first metal foil; a resin layer disposed on one surface of the first metal foil and formed of the resin composition; and a second metal foil disposed on the resin layer. In this case, the first metal foil and the second metal foil may be the same as or different from each other.

According to another example, the metal foil laminate according to the present disclosure comprises a metal foil; and a prepreg disposed on one surface or both surfaces of the metal foil and comprising the resin composition. In this case, the prepreg may be a single layer or a plurality of layers.

According to another example, the metal foil laminate according to the present disclosure comprises a first metal foil; a prepreg disposed on one surface of the first metal foil and comprising the resin composition; and a second metal foil disposed on the prepreg. In this case, the first metal foil and the second metal foil may be the same as or different from each other.

Here, the metal foil laminate may be a roll-type laminate produced by a roll-to-roll process, or a sheet-type (non-roll-type) laminate cut to a predetermined size.

The metal foil and the first and second metal foils may be made of a general metal or alloy known in the art without limitation, and may be, for example, a thin film of one metal selected from the group consisting of copper (Cu), iron (Fe), nickel (Ni), titanium (Ti), aluminum (Al), silver (Ag), and gold (Au), or an alloy thin film of two or more thereof. For example, the metal foil and the first and second metal foils may be a copper foil having excellent electrical conductivity and a low price. In this case, the copper foil may be any conventional copper foil known in the art without limitation, and may be produced by a rolling method or an electrolytic method, and may be subjected to an anti-rust treatment to prevent surface oxidation and corrosion.

The surface roughness (Rz) of a matte side of the metal foil and the first and second metal foils may range from about 0.1 µm to 10 µm, respectively. In this case, the surface roughness (Rz) of a matte surface of the first metal foil and the surface roughness (Rz) of a matte surface of the second metal foil may be the same as or different from each other.

The thicknesses of the metal foil and the first and second metal foils are not particularly limited, but may be in the range of about 9 µm to 70 µm in consideration of the thickness and mechanical properties of the final product.

The aforementioned metal foil laminate may be manufactured by any method known in the art. For example, a copper foil laminate may be obtained by laminating a prepreg on one surface of a first copper foil, placing a second copper foil thereon, and then performing heat-press lamination.

### <Printed Circuit Board>

Meanwhile, the present disclosure provides a printed circuit board comprising the aforementioned resin composition.

The printed circuit board of the present disclosure refers to a board in which one or more layers are laminated by a plated through-hole method or a build-up method, and may be obtained by superimposing the aforementioned prepreg or laminated sheet on an inner layer wiring board and performing heat-press molding.

According to an example, the printed circuit board according to the present disclosure comprises the aforementioned metal foil laminate. In this case, a circuit pattern may be formed on the metal foil, such as the first metal foil and/or the second metal foil, included in the metal foil laminate. In addition, the resin layer or the prepreg included in the metal foil laminate serves as an insulating support member.

The printed circuit board may be manufactured by a conventional method known in the art. For example, the printed circuit board may be manufactured by continuously supplying a roll-type metal laminate using a roll-to-roll apparatus, opening a hole in the flexible metal laminate to perform through-hole plating, and then etching a metal foil such as a copper foil including a plating film to form a circuit.

As described above, the aforementioned resin composition has low permittivity and low dielectric loss tangent in a frequency band of about 3.5 GHz to 300 GHz, and has excellent heat resistance and molding processability. For this reason, the printed circuit board to which the resin composition is applied also has a small dielectric loss in a frequency band of about 3.5 GHz to 300 GHz to lower a transmission loss of an electric, electronic, or communication device, and has excellent heat resistance. Therefore, the printed circuit board of the present disclosure may be usefully applied to various electric, electronic, and communication devices including mobile communication devices handling high-frequency to ultra-high-frequency signals, base station devices thereof, network-related electronic devices such as servers and routers, large computers and automobile radar devices.

Hereinafter, the present disclosure will be described in detail through examples, but the following examples and experimental examples are merely illustrative of one embodiment of the present disclosure, and the scope of the present disclosure is not limited to the following examples and experimental examples.

### <Embodiment 1>

### 1-1. Preparation of resin composition

Each component was mixed according to the compositions described in Table 1 below to prepare a resin composition. In Table 1 below, the content (amount used) of each component is expressed in wt%, based on the total amount (100 wt%) of the resin composition.

### 1-2. Preparation of prepreg

After the prepared resin composition was impregnated into glass fiber, it was dried and heated at 150°C for 3 minutes to prepare a prepreg in a B-stage (semi-cured) state.

### 1-3. Preparation of copper-clad laminate

After laminating 1 ply of the prepreg prepared in Embodiment 1-2 onto a copper foil, the assembly was pressed at 200°C for 2 hours to prepare a copper-clad laminate having a thickness of 0.1 mm.

### 1-4. Preparation of printed circuit board

After applying a photosensitive dry film to the copper-clad laminate prepared in Embodiment 1-3 by laminating it under heat and pressure, light was irradiated using a master film having a circuit pattern, and a printed circuit board (PCB) was obtained through development. On the surface of the completed printed circuit board, copper foil including an unnecessary plating layer was removed by etching with a highly corrosive chemical, thereby forming a circuit pattern.

**[Table 1]**

| | Embodiment 1 | Embodiment 2 | Comparative Example 1 | Comparative Example 2 | Comparative Example 3 |
|---|---|---|---|---|---|
| A | 50 | 50 | 50 | 50 | 50 |
| B-1 | 30 | - | - | - | - |
| B-2 | - | 30 | - | - | 30 |
| B-3 | - | - | 30 | - | - |
| B-4 | - | - | - | 30 | - |
| C | 0.2 | 0.2 | 0.2 | 0.2 | - |
| D | 20 | 20 | 20 | 20 | 20 |

**[Table 2]**

| Configuration | | Detailed specifications |
|---|---|---|
| A | Polyphenylene oxide-based resin | Noryl SA90, SABIC |
| B-1 | Hollow inorganic filler with a porosity of 60% | Silica (D50 = 2.3um, Dk = 1.35, Df = 0.0005) |
| B-2 | Hollow inorganic filler with a porosity of 88% | S32HS, 3M (D50 = 22µm, Dk = 1.35, Df = 0.0043) |
| B-3 | General inorganic filler | SO-C2, Admatechs (D50 = 0.5um, Dk = 3.5, Df = 0.002) |
| B-4 | Hollow inorganic filler with a porosity of 38% | Silica (D50 = 0.6um, Dk = 2.8, Df = 0.003) |
| C | Dispersant | Triton X-100, Dow Corp |
| D | Fluoropolymer filler | PFA (Perfluoroalkoxy) (Dk=2.1, Df=0.0003, Tm=310°C, MFR=7g/10min, D50=25µm) |

### <Embodiment 2 and Comparative Examples 1-3>

A resin composition, a prepreg, a copper-clad laminate, and a printed circuit board were each manufactured in the same manner as in Embodiment 1, except that the compositions were changed as described in Table 1 above.

### <Experimental Example 1> - Evaluation of Physical Properties

Physical properties of the resin composition, prepreg, and copper-clad laminate prepared in Embodiments 1 and 2 and Comparative Examples 1 to 3 were evaluated by the following methods, and the results thereof are shown in Table 3 below.

### 1) Specific gravity of an insulator

The copper foil of each of the copper-clad laminates prepared in Embodiments 1 and 2 and Comparative Examples 1 to 3 was removed by wet etching using an etching solution (hydrochloric acid:hydrogen peroxide = 1:2 by volume), and the remaining insulator was then dried at 110°C for 2 hours to obtain samples. The specific gravity of the obtained sample was measured according to the water displacement method [ASTM D792 test method (at a temperature of 23±2°C)].

### 2) Dielectric constant (Dk) and dielectric loss (Df)

The copper foil of each of the copper-clad laminates prepared in Embodiments 1 and 2 and Comparative Examples 1 to 3 was removed by wet etching using an etching solution (hydrochloric acid:hydrogen peroxide = 1:2 by volume), and the remaining insulator was then dried at 110°C for 2 hours to obtain samples. For the obtained samples, the dielectric constant (Dk) and dielectric loss (Df) at 25 °C and 10 GHz were measured using the SPDR method (IEC 61189-2-721).

### 3) Coefficient of Thermal Expansion (CTE)

The copper foil of each of the copper-clad laminates prepared in Embodiments 1 and 2 and Comparative Examples 1 to 3 was removed by wet etching using an etching solution (hydrochloric acid:hydrogen peroxide = 1:2 by volume), and the remaining insulator was then dried at 110°C for 2 hours to obtain samples. Subsequently, the CTE in the X/Y direction was measured on the obtained samples using a Thermomechanical Analyzer (TMA) according to the IPC-TM-650 2.4.41.2 test method.

### 4) Resin flowability

The prepregs prepared in Embodiments 1 and 2 and Comparative Examples 1 to 3 were respectively pressed at 170°C and 5,700 lb for 5 minutes, and the degree of resin flow was visually inspected. At this time, when it was confirmed that the resin flowed outside the hot plate of the press, the resin flowability was evaluated as "O", and when the resin did not flow outside the hot plate, the resin flowability was evaluated as "X".

### 5) Peel Strength (P/S)

The peel strength at the interface between the copper foil and the resin composition in the copper-clad laminates prepared in Embodiments 1 and 2 and Comparative Examples 1 to 3 was measured in accordance with IPC-TM-650 2.4.8. At this time, if the peel strength at the point when the copper foil is peeled off from the resin composition is 0.4 kgf/cm² or higher, it was marked as "O"; if the peel strength is less than 0.4 kgf/cm², it was marked as "X".

### 6) Heat resistance

The copper-clad laminates prepared in Embodiments 1 and 2 and Comparative Examples 1 to 3 were evaluated in accordance with IPC-TM-650 2.3.13 (solder pot, 288 °C, 30 s), and visual changes were observed. At this time, samples with no visible abnormalities, such as swelling of the copper foil, were rated "O", whereas samples showing visible abnormalities were rated "X".

**[Table 3]**

| | Embodiment 1 | Embodiment 2 | Comparative Example 1 | Comparative Example 2 | Comparative Example 3 |
|---|---|---|---|---|---|
| Filler vol% | 55.5% | 64.6% | 20.3% | 29.2% | 64.7% |
| Insulator specific gravity | 0.82 | 0.65 | 1.46 | 1.3 | 0.65 |
| Dk | 1.79 | 1.68 | 2.53 | 2.44 | 1.68 |
| Df | 0.001 | 0.002 | 0.003 | 0.003 | 0.002 |
| CTE (ppm/°C) | 50 | 30 | 60 | 50 | 30 |
| Resin flowability | ○ | ○ | ○ | ○ | × |
| Peel strength | ○ | ○ | ○ | ○ | ○ |
| Heat resistance | ○ | ○ | ○ | ○ | × |

## Claims

1. A resin composition comprising: a polyphenylene oxide-based resin;
a hollow inorganic filler having a porosity of 60% to 90%; and
a dispersant.

2. The resin composition of claim 1, wherein
the hollow inorganic filler has a dielectric constant (Dk) in the range of 1 to 3 at 25°C and 10 GHz.

3. The resin composition of claim 2, wherein
the hollow inorganic filler has an average particle size (D50) in the range of 0.5µm to 50 µm.

4. The resin composition of claim 3, wherein
the hollow inorganic filler comprises hollow silica.

5. The resin composition of claim 1,
further comprising a fluoropolymer filler.

6. The resin composition of claim 5, wherein
the fluoropolymer filler has a dielectric constant (Dk) in the range of 2 to 3 at 25°C and 10 GHz.

7. The resin composition of claim 5, wherein
the fluoropolymer filler contains one or more selected from the group consisting of polytetrafluoroethylene (PTFE), perfluoroalkoxyalkane (PFA), tetrafluoroethylene-hexafluoropropylene copolymer (FEP), polychlorotrifluoroethylene (PCTFE), ethylene-tetrafluoroethylene copolymer (ETFE), tetrafluoroethylene-chlorotrifluoroethylene copolymer (TFE/CTFE), ethylene-chlorotrifluoroethylene copolymer (ECTFE), and polychlorotrifluoroethylene (PCTFE).

8. The resin composition of claim 1, wherein
the dispersant contains a non-ionic dispersant.

9. The resin composition of claim 1, wherein
the dispersant contains one or more selected from the group consisting of polyoxyethylene glycol alkylphenol ether-based dispersants, polysorbate-based dispersants, and poly(oxyethylene)alkyl ether-based dispersants.

10. The resin composition of claim 1,
further comprising at least one selected from the group consisting of a curing agent, an initiator, an additive, and a solvent.

11. The resin composition of claim 1,
comprising, based on a total weight of the resin composition:
10 to 70 wt% of polyphenylene oxide-based resin;
5 to 40 wt% of hollow inorganic filler; and
0.0001 to 5 wt% of dispersant.

12. The resin composition of claim 1, wherein
a cured product has a dielectric constant (Dₖ) in the range of 1.5 to 2.2 at 25°C and 10 GHz.

13. A prepreg comprising the resin composition of any one of claims 1 to 12.

14. The prepreg of claim 13,
having a dielectric constant (Dₖ) of 2.5 or less at 25°C and 10 GHz.

15. A metal foil laminate comprising the resin composition of any one of claims 1 to 12.

16. A printed circuit board comprising the resin composition of any one of claims 1 to 12.
